Europäisches Patentamt

European Patent Office

Office européen des brevets

(19)

(11) **EP 1 222 735 B1**

(12) **FASCICULE DE BREVET EUROPEEN**

(45) Date de publication et mention
de la délivrance du brevet:
**25.02.2004 Bulletin 2004/09**

(21) Numéro de dépôt: **00966253.7**

(22) Date de dépôt: **28.09.2000**

(51) Int Cl.⁷: **H03H 9/02**, H03H 9/64

(86) Numéro de dépôt international:
**PCT/FR2000/002727**

(87) Numéro de publication internationale:
**WO 2001/029964 (26.04.2001 Gazette 2001/17)**

(54) **FILTRE A ONDES ACOUSTIQUES D'INTERFACE NOTAMMENT POUR LES LIAISONS SANS FIL**

AKUSTISCHES GRENZFLÄCHENWELLENFILTER INSBESONDERE FÜR DRAHTLOSE ÜBERTRAGUNGSSYSTEME

INTERFACE ACOUSTIC WAVE FILTER, ESPECIALLY FOR WIRELESS CONNECTIONS

(84) Etats contractants désignés:
**AT BE CH CY DE DK ES FI FR GB GR IE IT LI LU MC NL PT SE**

(30) Priorité: **15.10.1999 FR 9912992**

(43) Date de publication de la demande:
**17.07.2002 Bulletin 2002/29**

(73) Titulaire: **Tournois, Pierre**
**75013 Paris (FR)**

(72) Inventeur: **Tournois, Pierre**
**75013 Paris (FR)**

(74) Mandataire: **de Saint-Palais, Arnaud Marie Cabinet Moutard,**
**35, rue de la Paroisse**
**78000 Versailles (FR)**

(56) Documents cités:
**FR-A- 2 145 750** **US-A- 4 484 098**

• **W.J.GHIJSEN ET AL: "A RIGOROUS COMPUTATIONAL TECHNIQUE FOR THE ACOUSTO-ELECTRIC FIELD PROBLEM IN SAW DEVICES" IEEE TRANSACTIONS ON ULTRASONICS, FERROELECTRICS AND FREQUENCY CONTROL., vol. 33, no. 4, juillet 1986 (1986-07), pages 375-384, XP002140789 IEEE INC. NEW.YORK., US ISSN: 0885-3010**

## Description

La présente invention telle que definie dans les revendications concerne un filtre à ondes acoustiques de structure plane, c'est-à-dire dans lequel des ondes acoustiques se propagent dans un plan.

Elle s'applique notamment, mais non exclusivement, aux liaisons de communication sans fil comme celles utilisées dans la téléphonie mobile ou les clés destinées à la commande à distance de l'ouverture des portes d'une automobile, ou encore dans l'échange sans fil de données entre appareils électriques ou informatiques délocalisés. Ces liaisons sans fil utilisent des filtres en tête, appelés RF (Radio Frequency Filters) et des filtres de fréquence intermédiaire FI à ondes acoustiques de surface (Surface Acoustic Wave Filters).

Un filtre à ondes acoustiques de surface est généralement constitué par un substrat piézoélectrique qui sous l'effet d'un champ électrique génère des ondes acoustiques qui se propagent à la surface du substrat, ces ondes étant soit situées dans le plan sagittal (ondes de Rayleigh), soit orientées transversalement (ondes de Bleustein-Gulayev) ou quasi transversalement par rapport à leur direction de propagation.

Pour générer ces ondes acoustiques, le substrat comprend une structure métallique plane formée par un dépôt métallique déposé sur le substrat ou enterré dans des sillons formés à sa surface, cette structure métallique plane comprenant une pluralité de doigts formant par exemple des peignes interdigités, ou formant un transducteur de type SPUDT (Single Phase UniDirectional Transducer), de type R-SPUDT (Resonant SPUDT) ou des résonateurs couplés acoustiquement

ou électriquement. Pour plus d'informations sur ces dispositifs, on peut se référer aux documents [4] à [8] qui sont mentionnés dans la liste des références figurant à la fin de la présente description, et qui sont incorporés dans la présente description à titre de référence.

Les avantages des filtres à ondes acoustiques de surface par rapport aux filtres utilisant une autre technologie résident dans leurs très faibles dimensions, leur faible consommation (ce sont des filtres passifs) et surtout leur faible coût de fabrication.

Toutefois, les fréquences porteuses utilisées dans la téléphonie mobile ont tendance à augmenter, depuis 900 MHz à 1800 MHz, pour atteindre 2200 MHz, voire 3000 MHz et plus. La taille du substrat, l'intervalle entre les doigts et surtout la dimension des doigts de la structure métallique doivent donc être réduites en conséquence pour pouvoir traiter des fréquences aussi élevées. Ainsi, la précision des machines de lithographie nécessaire à la réalisation des gravures métalliques doit passer de 0,5 $\mu$m à 0,35 $\mu$m, voire beaucoup moins (0,25 à 0,18 $\mu$m).

Par ailleurs la présence de la moindre poussière ou projection de matière dégrade les performances du filtre, et ce d'autant plus que les dimensions du substrat doivent être de plus en plus réduites.

Il est donc nécessaire que le substrat soit protégé par un boîtier.

En outre, comme le substrat est piézoélectrique, il doit également être protégé des perturbations électromagnétiques. Par conséquent, le boîtier doit être blindé.

Il en résulte donc un problème de structure du coût des composants, puisqu'en devenant de plus en plus petites, les puces acoustiques vont coûter beaucoup moins cher que le boîtier destiné à protéger la puce de l'environnement.

La présente invention a pour but de supprimer ces inconvénients. A cet effet, elle propose un filtre acoustique de structure plane dans lequel des ondes acoustiques se propagent sensiblement dans un plan.

Selon l'invention, ce filtre est caractérisé en ce qu'il comprend deux corps solides dont l'un au moins est piézoélectrique, ces corps étant liés l'un à l'autre de manière à présenter une interface plane entre eux, les ondes acoustiques étant générées par le corps piézoélectrique au moyen d'un champ électrique, les ondes acoustiques étant guidées par l'interface entre les deux corps solides et présentant une énergie acoustique qui décroît exponentiellement dans les deux corps à partir de l'interface dans une direction perpendiculaire à l'interface.

Grâce à ces dispositions, les ondes acoustiques se propagent non pas à la surface d'un substrat, mais à l'interface entre deux corps solides. L'énergie de ces ondes décroît exponentiellement dans les deux corps solides à partir de l'interface, si bien qu'aucune énergie ne sort à l'extérieur de la structure dès lors que l'épaisseur des corps solides est supérieure à quelques dizaines de fois la longueur d'onde des ondes acoustiques. Par conséquent, aucun boîtier n'est nécessaire pour protéger le composant (le filtre) de son environnement. Par ailleurs, les ondes acoustiques se propageant à l'interface entre deux milieux solides, elles peuvent présenter une vitesse de propagation supérieure à celle des ondes de surface (par exemple 5000 m/s au lieu de 3000 m/s).

Ces ondes d'interface, qui sont non dispersives, peuvent présenter deux types de polarisation principales : lorsque le vecteur déplacement des atomes de la matière se situe uniquement dans le plan sagittal (perpendiculaire au plan d'interface), ce sont les ondes de Stoneley, lorsque ce vecteur déplacement se situe uniquement suivant la direction perpendiculaire au plan sagittal ce sont les ondes d'interface transversales de Maerfeld-Tournois. Une description plus détaillée de ces ondes est par exemple donnée dans les documents [1], [2] et [3] mentionnés à la fin de la présente description et qui sont intégrés à la présente description à titre de référence.

De préférence on utilise les ondes d'interface transversales ou quasi transversales, dont les conditions d'existence sont moins drastiques que celles des ondes de Stoneley et dont la vitesse de propagation est généralement plus grande.

Avantageusement, les axes cristallographiques des matériaux constituant les deux corps sont choisis de telle sorte que la composante transversale du vecteur déplacement de l'onde dans le plan de l'interface soit la seule composante du vecteur déplacement ou soit dominante, et que l'onde soit couplée piézoélectriquement.

Un seul des deux corps peut être constitué d'un matériau piézoélectrique ou les deux. Dans ce dernier cas, les deux matériaux piézoélectriques peuvent être identiques. Ils peuvent également être assemblés de manière à présenter les mêmes orientations cristallines pour former un seul corps solide. Dans ce cas, la structure plane métallique formant le filtre, formée à l'interface entre les deux corps sert de guide piézoélectrique à l'onde d'interface transversale (SH) ou quasi-transversale (Q-SH).

Dans le cas où l'un des matériaux est piézoélectrique et l'autre non piézoélectrique, les axes cristallographiques du matériau piézoélectrique sont de préférence choisis de telle manière que selon la direction de propagation, le vecteur de déplacement des ondes acoustiques soit purement transversal-horizontal ou présente une composante transversale-horizontale dominante, et telle que ces ondes soient couplées piézoélectriquement.

Les axes cristallographiques du matériau non piézoélectrique peuvent également être choisis pour que selon la direction de propagation choisie, le vecteur de déplacement des ondes acoustiques soit purement transversal-horizontal ou présente une composante transversale-horizontale dominante, et telle que ces ondes aient une vitesse de propagation égale ou supérieure à la vitesse de propagation des ondes transversales-horizontales ou quasi-transversales-horizontales dans le matériau piézoélectrique.

Selon une particularité de l'invention, la constante diélectrique et la densité du matériau non piézoélectrique sont inférieures respectivement à la constante diélectrique et à la densité du matériau piézoélectrique.

Un mode de réalisation du filtre selon l'invention sera décrit ci-après, à titre d'exemple non limitatif, avec référence aux dessins annexés dans lesquels

La figure 1 représente schématiquement en perspective un filtre selon l'invention dans lequel sont montrées les ondes acoustiques se propageant à l'interface entre les deux corps solides ;

La figure 2 représente schématiquement en perspective un filtre selon l'invention comprenant à l'interface entre les deux corps solides un transducteur interdigité ;

La figure 3 montre deux courbes délimitant le domaine d'existence des ondes d'interface transversales ou quasi transversales.

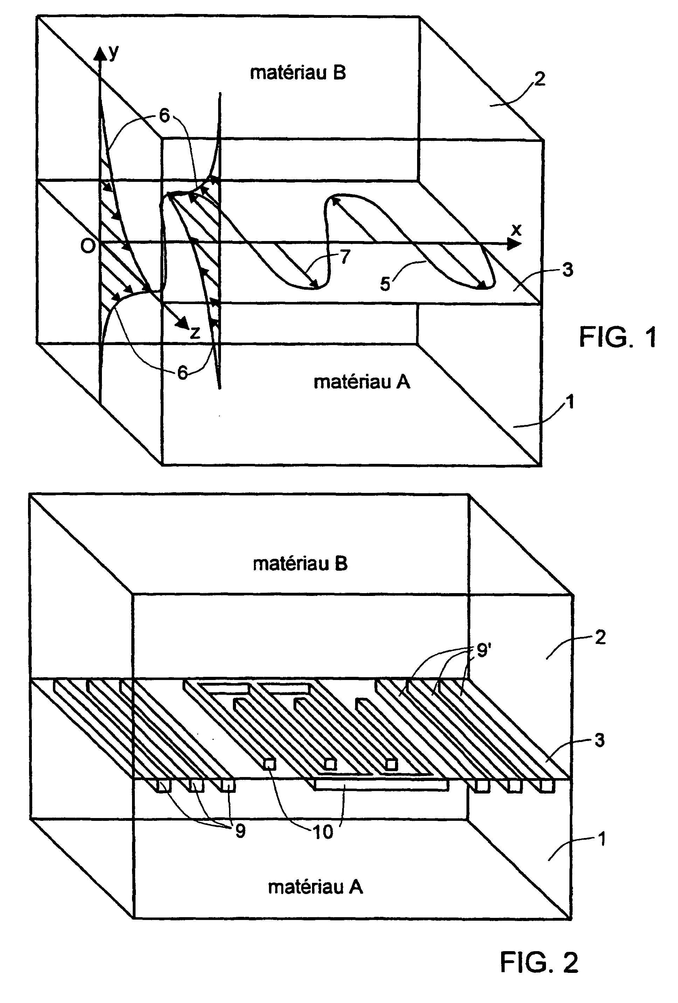

La figure 1 représente un filtre à ondes acoustiques conforme à la présente invention. Ce filtre comprend deux corps solides 1, 2 par exemple de forme parallélépipédique, ayant une face l'une contre l'autre de manière à former une interface 3 située dans un plan xOz. L'un 1 des deux corps solides 1, 2 est en un matériau A piézoélectrique, tandis que l'autre est en un matériau B piézoélectrique, identique ou non au matériau A, ou bien non piézoélectrique.

Les axes cristallographiques des corps 1 et 2 sont choisis de manière à ce que si l'on engendre des ondes acoustiques 5 se propageant dans la direction Ox, au voisinage du plan d'interface 3, l'énergie de ces ondes décroît exponentiellement dans les deux corps à partir de l'interface dans une direction Oy perpendiculaire à celle-ci, comme le montrent les courbes exponentielles 6. De cette manière, aucune énergie ne sort à l'extérieur de la structure, si les corps 1 et 2 sont suffisamment épais (dans la direction Oy sur la figure 1), de l'ordre de quelques dizaines de fois la longueur d'onde des ondes acoustiques.

Il n'est donc pas nécessaire de prévoir un packaging pour protéger le composant (le filtre) de son environnement.

Ces ondes, qui sont non dispersives, peuvent présenter deux types de polarisation principales : lorsque le vecteur déplacement 7 des atomes de la matière se situe uniquement dans le plan sagittal xOy, ce sont les ondes de Stoneley (voir référence [1]), lorsque ce vecteur déplacement se situe uniquement suivant la direction Oz perpendiculaire au plan sagittal (cas de l'onde représentée sur la figure 1), ce sont des ondes d'interface transversales de Maerfeld-Tournois (voir références [2] et [3]).

De préférence, le filtre selon l'invention utilise des ondes d'interface transversales dont les conditions d'existence sont moins drastiques que celles des ondes de Stoneley et dont la vitesse de propagation est généralement plus grande.

Sur la figure 2, le filtre à ondes acoustiques selon l'invention comprend, placée à l'interface 3 entre les deux matériaux A et B, une structure de filtre plane conductrice, par exemple métallique, semblable à celle des composants à ondes de surface, telle que les peignes interdigités (voir référence [4] ), les transducteurs SPUDT (voir référence [5]) ou R-SPUDT (voir référence [6]), et les résonateurs à ondes couplées acoustiquement (voir référence [7]) ou couplés électriquement (voir référence [8]). Cette structure conductrice permet de générer les ondes acoustiques, la forme et la disposition de cette structure définissant les caractéristiques du filtre.

Cette structure est par exemple constituée par un réseau de conducteurs électriques obtenu par un dépôt métallique formé à l'interface entre les deux corps 1, 2, enterré dans des sillons creusés dans l'un des deux corps 1, 2 à l'interface 3, par exemple dans le corps 1. Elle comprend par exemple deux réflecteurs constitués de segments de conducteurs 9, 9' perpendiculaires à la direction de propagation des ondes acoustiques, et entre les segments de conducteurs 9 et 9', un transducteur constitué de deux peignes 10 interdigités, par ayant une pluralité de doigts.

Nous allons étudier plus en détail successivement les cas où les deux corps 1, 2 semi-infinis sont piézoélectriques, et où un seul des deux corps est piézoélectrique.

1 - Les deux matériaux sont piézoélectriques

Lorsque les deux matériaux A et B sont issus de la classe cristallographique hexagonale avec l'axe C aligné suivant l'axe Oz, perpendiculaire au plan sagittal, la vitesse $v_{CC}$ de ces ondes acoustiques est donnée par :

$$\rho_A v_A^2 \left(1-\frac{v_{CC}^2}{v_A^2}\right)^{1/2} + \rho_B v_B^2 \left(1-\frac{v_{CC}^2}{v_B^2}\right)^{1/2} = \frac{e_A^2}{\varepsilon_A} + \frac{e_B^2}{\varepsilon_B} \tag{1}$$

lorsqu'à l'interface les charges piézoélectriques sont court-circuitées par un film métallique infiniment mince.

Au contraire, lorsqu'à l'interface 3, les charges piézoélectriques ne sont pas court-circuitées, la vitesse $v_{NC}$ de ces ondes est donnée est donnée par :

$$\rho_A v_A^2 \left(1-\frac{v_{NC}^2}{v_A^2}\right)^{1/2} + \rho_B v_B^2 \left(1-\frac{v_{NC}^2}{v_B^2}\right)^{1/2} = \frac{\left(\frac{e_A}{\varepsilon_A} - \frac{e_B}{\varepsilon_B}\right)^2}{\frac{1}{\varepsilon_A} + \frac{1}{\varepsilon_B}} \tag{2}$$

Dans ces équations (1) et (2), $\varepsilon_A$ et $\varepsilon_B$ sont les constantes diélectriques des matériaux A et B, $e_A$ et $e_B$ sont les coefficients $(e_{15})_A$ et $(e_{15})_B$ des tenseurs piézoélectriques, et $v_A$ et $v_B$ sont les vitesses de propagation transversales de ces ondes acoustiques dans les matériaux A et B.

Si les deux matériaux sont identiques et de même orientation $\rho_A = \rho_B = \rho$ ; $v_A = V_B = V_S$ ; $\varepsilon_A = \varepsilon_B = \varepsilon$ ; et $e_A = e_B = e_{15}$.

Lorsqu'à l'interface les charges piézoélectriques sont court-circuitées, la vitesse $v_{CC}$ de ces ondes est donnée par :

$$\left(1-\frac{v_{CC}^2}{v_S^2}\right)^{1/2} = \frac{e_{15}^2}{\varepsilon \rho v_S^2} = \bar{K}^2 \tag{3}$$

$\bar{K}^2$ étant le coefficient de couplage piézoélectrique du matériau.

Si au contraire, les charges piézoélectriques à l'interface ne sont pas court-circuitées, l'onde d'interface est dégénérée et se confond avec l'onde transversale de volume de vitesse $v_S$.

Dans ce cas, l'onde d'interface existe et n'est pas dégénérée, et sa vitesse v est proche de la vitesse $v_{CC}$.

Le coefficient de couplage $2\Delta v/v$ de cette onde est alors voisin de :

$$\frac{2\Delta v}{v} \cong \frac{v_S^2 - v_{CC}^2}{v_S^2} = \bar{K}^4 \tag{4}$$

Pour réaliser un filtre acoustique d'interface dans un matériau piézoélectrique unique, il faut donc :

- choisir une orientation des axes cristallographiques du cristal piézoélectrique telle que selon la direction de propagation Ox choisie, l'onde soit purement transversale ou dont la composante transversale du vecteur déplacement 7 soit dominante, et telle que cette onde soit piézoélectriquement couplée,

- couper le cristal suivant un plan parallèle à la composante transversale du vecteur 7 déplacement et à la direction de propagation de l'onde, et

- déposer ou mieux enterrer au moyen de sillons gravés d'épaisseur contrôlée par tous les procédés classiques relatifs aux ondes acoustiques de surface, la structure de filtre plan, de type peignes interdigités, SPUDT, R-SPUDT ou résonateurs couplés acoustiquement ou électriquement, sur la face obtenue à la suite du découpage, de l'une des parties du cristal piézoélectrique qui a été coupé (figure 2), et

- replacer suivant les mêmes orientations cristallines la deuxième partie du cristal qui a été coupée sur la première au moyen d'une adhérence moléculaire ou de tout autre moyen d'adhérence élastique.

En ce qui concerne la conception des filtres plans, celle-ci pourra être grandement simplifiée en remarquant qu'en raison de la symétrie de son interface, la structure d'onde d'interface peut être obtenue par superposition mathématique de deux demi structures à ondes de surface transversales dont les constantes diélectriques seraient $\varepsilon$ à l'intérieur du corps piézoélectrique et $\varepsilon_0 = 0$ à l'extérieur du corps piézoélectrique.

A titre d'exemple pour l'onde d'interface transversale pure (SH), on peut prendre un matériau piézoélectrique de la classe hexagonale 6 mm dont l'axe cristallographique C est dans le plan de l'interface, perpendiculairement à la direction de propagation, comme le Titanate de Plomb et de Zirconium (PZT).

Pour l'onde quasi-transversale (Q-SH), on peut prendre des coupes suivant l'axe cristallographique Y (où Y est tourné d'un certain angle par exemple 175°) du Niobate de Lithium (YX-LiNbO$_3$) ou du Tantalate de Lithium (YX-LiTaO$_3$), la propagation s'effectuant sur l'axe cristallographique X. On peut prendre aussi la coupe ST du Quartz, la propagation s'effectuant sur l'axe cristallographique X (ST-X quartz).

2 - L'un des deux corps est piézoélectrique et l'autre nonpiézoélectrique

Une onde acoustique d'interface purement transverse, peut exister entre deux matériaux dont l'un est non piézoélectrique de densité $\rho_{NP}$ et de vitesse $v_{NP}$ et l'autre piézoélectrique de densité $\rho_P$ et de vitesse $v_P$, choisi dans la classe cristalline des 6 mm avec l'axe cristallographique C dans le plan xOz de l'interface, perpendiculairement à la direction de propagation Ox de l'onde (Figure 1).

La vitesse v de cette onde est donnée par :

$$\left(1-\frac{v^2}{v_P^2}\right)^{1/2} + \frac{\rho_{NP}}{\rho_P}\left(\frac{v_{NP}}{v_P}\right)^2 \left(1-\frac{v^2}{v_{NP}^2}\right)^{1/2} = \eta^2 \tag{5}$$

$\eta^2$ étant un coefficient de couplage piézoélectrique effectif donné par :

$$\eta^2 = \bar{K}^2 = \frac{e^2}{\varepsilon_P \rho_P v_P^2} \tag{6}$$

lorsqu'à l'interface les charges piézoélectriques sont court-circuitées par un film métallique infiniment mince ou par un matériau non piézoélectrique conducteur, et par :

$$\eta^2 = \frac{\bar{K}^2}{\left(1+\frac{\varepsilon_P}{\varepsilon_{NP}}\right)} \tag{7}$$

lorsqu'à l'interface les charges piézoélectriques ne sont pas court-circuitées.

Dans ces équations, $\varepsilon_P$ et $\varepsilon_{NP}$ sont les constantes diélectriques respectivement du corps piézoélectrique et du corps non piézoélectrique, $e = e_{15}$ est un coefficient du tenseur piézoélectrique et $\bar{K}^2$ est le coefficient de couplage piézoélectrique.

Pour déterminer les conditions d'existence de ces ondes d'interface, examinons les trois termes de l'équation (5). Ces termes doivent être réels et positifs, la vitesse v est donc inférieure ou au plus égale à la plus petite des vitesses $v_P$ et $v_{NP}$. Si v est égale à $v_{NP} \leq v_P$, le deuxième terme s'annule et lorsque v décroît, les deux premiers termes augmentent. $\eta^2$ doit donc être supérieur au premier terme lorsque $v = v_{NP}$.

Si la vitesse v est égale à $v_P \leq v_{NP}$, le premier terme s'annule et lorsque v décroît les deux premiers termes augmentent $\eta^2$ doit donc aussi être supérieur au deuxième terme lorsque $v = v_P$.

Les conditions d'existence sont donc données par le couple d'inégalités suivantes :

$$\left(1 - \frac{v_{NP}^2}{v_P^2}\right)^{1/2} \leq \eta^2 \qquad \text{pour} \quad \frac{v_{NP}}{v_P} \leq 1$$

$$\frac{\rho_{NP}}{\rho_P}\left(\frac{v_{NP}}{v_P}\right)^2\left(1 - \frac{v_P^2}{v_{NP}^2}\right)^{1/2} \leq \eta^2 \qquad \text{pour} \quad \frac{v_{NP}}{v_P} \geq 1 \qquad (8)$$

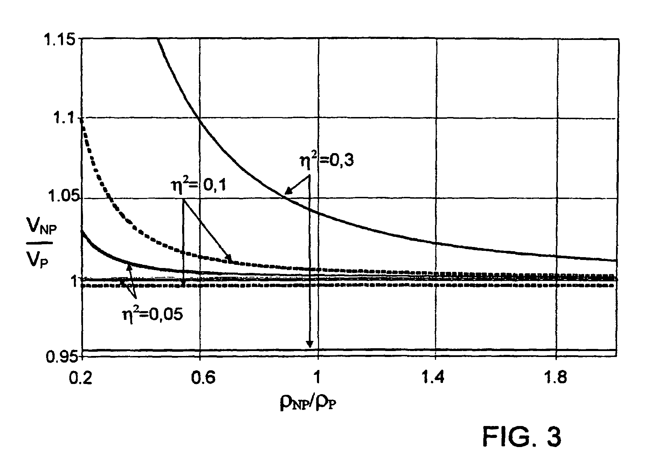

Sur la figure 3, on a tracé pour différentes valeurs de $\eta^2$ (0,05 ; 0,1 et 0,3) les deux courbes $v_{NP}/v_P$ en fonction de $\rho_{NP}/\rho_p$ qui délimitent le domaine d'existence de ces ondes, tel que défini par les inégalités (8). On peut y remarquer que ces ondes existent toujours quelque soit $\rho_{NP}/\rho_P$, lorsque $v_{NP} = v_P = v_S$. Dans ces conditions leur vitesse v est donnée par :

$$\left(\frac{1 - v^2}{v_S^2}\right)^{1/2} = \frac{\eta^2}{\left(1 + \frac{\rho_{NP}}{\rho_P}\right)} \qquad (9)$$

On peut y remarquer aussi que plus $\rho_{NP}$ est petit devant $\rho_P$, plus le domaine d'existence s'élargit à des vitesses $v_{NP}$ supérieures à $v_P$. Par ailleurs, plus $\eta^2$ sera grand et plus $\rho_{NP}$ sera petit devant $\rho_P$, plus les ondes seront localisées près de l'interface.
Le coefficient de couplage $2\Delta v/v$ de ces ondes peut être aisément calculé à partir de la vitesse $v_{CC}$ lorsque l'interface est court-circuitée, ou de la vitesse $v_{NC}$ lorsque l'interface n'est pas court-circuitée. Lorsque $v_{NP} = v_P = v_S$. On trouve :

.

$$\frac{2\Delta v}{v} \cong \frac{v_{NC}^2 - v_{CC}^2}{v_S^2} = \frac{\overline{K^4}}{\left(1 + \frac{\rho_{NP}}{\rho_P}\right)^2}\left[1 - \frac{1}{\left(1 + \frac{\varepsilon_P}{\varepsilon_{NP}}\right)^2}\right] \qquad (10)$$

Le coefficient de couplage sera donc d'autant plus grand que $\overline{K}^2$ sera grand, que $\rho_{NP}$ sera inférieur à $\rho_P$ et que $\varepsilon_{NP}$ sera inférieur à $\varepsilon_P$.
Afin d'aider à la sélection des couples de matériaux pouvant propager ces ondes d'interface transversales, on a indiqué dans le tableau 1 suivant la vitesse transversale v d'un certain nombre de matériaux ainsi que leur densité p et leur constante diélectrique relative $\varepsilon$.

Tableau 1

|  | Matériaux | v (m/s) | $\rho$ (kg/m3) | $\varepsilon$ |
|---|---|---|---|---|
| 1 | AIN | 6300 | 3050 | ? |
| 2 | $Li_2B_4O_7$ | 3000 - 4450 | 2600 | ? |
| 3 | $LiNbO_3$ | 3500 - 4850 | 4700 | 44 |
| 4 | $LiTaO_3$ | 3350 - 4400 | 7450 | 41 |
| 5 | Quartz | 3100 - 3900 | 2651 | 4.5 |
| 6 | ZnO | 2800 | 5680 | 8,55 |
| 7 | PZT | 2450 | 7500 | 1700 |
| 8 | $Bi_{12}GeO_{20}$ | 1800 | 9200 | ? |
| 9 | $Al_2O_3$ | 6200 | 4000 | 9,34 |
| 10 | Si | 5450 | 2332 | 11.7 |

EP 1 222 735 B1

Tableau 1 (suite)

| | Matériaux | v (m/s) | ρ (kg/m3) | ε |
|---|---|---|---|---|
| 11 | YAG | 5100 | 4550 | ? |
| 12 | $SiO_2$ | 3900 | 2050 | 3.78 |

Dans ce tableau, les matériaux 1 à 8 sont piézoélectriques et les matériaux 9 à 12 non piézoélectriques.

Pour réaliser un filtre acoustique à l'interface entre un matériau piézoélectrique et un matériau non piézoélectrique, il faut donc :

- choisir une orientation des axes cristallographiques du cristal piézoélectrique telle que selon la direction de propagation choisie, l'onde soit purement transversale ou dont la composante transversale du vecteur déplacement 7 soit dominante et telle que cette onde soit piézoélectriquement couplée,

- choisir une orientation des axes cristallographiques du cristal non piézoélectrique telle que selon la direction de propagation choisie, l'onde soit purement transversale ou dont la composante transversale du vecteur déplacement 7 soit dominante et telle que cette onde ait une vitesse de propagation égale ou supérieure à la vitesse des ondes transversales ou quasi-transversale dans le corps piézoélectrique,

- choisir si possible un cristal non piézoélectrique de densité inférieure à celle du cristal piézoélectrique, et

- choisir si possible un cristal non piézoélectrique de constante diélectrique inférieure à celle du cristal piézoélectrique.

Pour satisfaire les conditions d'existence d'ondes d'interface quasi-transversales, (Q-SH), on tourne légèrement les cristaux l'un par rapport à l'autre autour d'un axe perpendiculaire à leur interface, depuis les orientations cristallines décrites.

Selon une particularité de l'invention, sur la surface de l'un des matériaux, on dépose ou on enterre dans des sillons gravés d'épaisseur contrôlée selon les axes adéquats, la structure métallique du filtre plan, comme représenté sur la figure 2. Ensuite on adhère à cette surface l'autre matériau selon les axes adéquats au moyen de tout procédé envisageable d'adhérence élastique.

A titre d'exemple, on peut adhérer un cristal de YAG non piézoélectrique sur un cristal de Niobate de Lithium (LiNbO$_3$) piézoélectrique ou sur un cristal de Tantalate de Lithium (LiTaO$_3$) piézoélectrique, de coupe suivant l'axe cristallographique Y, la propagation se faisant suivant l'axe cristallographique X.

Selon une autre variante du filtre selon l'invention, l'un des deux corps 1, 2 est cristallin et l'autre est obtenu par un dépôt ou une épitaxie. Dans ces conditions, à la surface du matériau cristallin, on dépose ou on enterre dans des sillons gravés d'épaisseur contrôlée, selon les axes adéquats, la structure métallique qui compose le filtre plan et on dépose ou on forme par épitaxie le second matériau selon les axes adéquats à la surface ainsi préparée du matériau cristallin.

On peut ainsi déposer du silicium amorphe (Si) non piézoélectrique sur une surface ainsi préparée de Niobate de Lithium YX-LiNbO$_3$ piézoélectrique, de coupe Y (où Y est tourné d'un certain angle) la propagation s'effectuant suivant l'axe X. On peut aussi former par épitaxie une couche de Nitrure d'Aluminium (AlN) piézoélectrique sur une surface de Saphir (Al$_2$O$_3$) non piézoélectrique.

LISTE DES REFERENCES CITEES DANS LA DESCRIPTION

[1] R. Stoneley, Proc. Roy. Soc. (London) A 106, 416 (1924)

[2] C. Maerfeld and P. Tournois, Appl. Phys. Lett. 19, 117 (1971)

[3] B. Auld, Acoustic Fields and Waves in Solids, vol. 2, pages 145-151, John Wiley, New York (1973)

[4] D.P. Morgan, Surface Wave Devices for Signal Processing, Eisevier, New York (1985)

[5] C.S. Hartmann, P.V. Wright, R.J. Kansy and E.M. Garber, An Analysis of SAW Interdigital Transducers with Internal Reflections and the Application to the Design of Single Phase Unidirectional Transducers, IEEE Ultrasonic Symp. Proc., p. 40-45 (1982)

[6] P. Ventura, M. Solal, P. Dufilue, J.M. Hodé and F. Roux, A New Concept in SPUDT design : the RSPUDT (Resonant SPUDT), IEEE Ultrasonic Symp. Proc., p. 1-6 (1994)

[7] L.A. Coldren, RL. Rosenberg and J.A. Rentschler, Monolithic Transversaly Coupled Saw Resonator Filters, IEEE Ultrasonic Symp. Proc., p. 888-893 (1977)

[8] P.F. Cross, RF. Smith ans W.H. Haydl, Electronic Letters, vol. 11, p. 244-245 (may 1975)

**Revendications**

1. Filtre acoustique de structure plane dans lequel des ondes acoustiques se propagent sensiblement dans un plan, **caractérisé en ce qu'**il comprend deux corps solides (1, 2) dont l'un au moins est piézoélectrique, ces corps étant liés l'un à l'autre de manière à présenter une interface (3) plane entre eux, les ondes acoustiques étant générées par le corps piézoélectrique au moyen d'un champ électrique, et guidées par l'interface entre les deux corps solides, les corps solides étant choisis de manière à ce que ces ondes présentent une énergie acoustique qui décroît exponentiellement dans les deux corps à partir de l'interface dans une direction (Oy) perpendiculaire à l'interface, le vecteur de déplacement des atomes de matière lié à ces ondes se situant dans un plan perpendiculaire à la susdite interface plane (3) séparant les deux corps solides (1,2).

2. Filtre acoustique selon la revendication 1, **caractérisé en ce que** les axes cristallographiques des matériaux constituant les deux corps (1, 2) sont choisis de manière à obtenir à l'interface (3) des ondes acoustiques transversales (SH) ou quasi-transversales (Q-SH), dont le vecteur déplacement (7) présente une seule composante qui est transversale dans le plan de l'interface (3) ou une composante transversale dominante, et que l'onde soit couplée piézoélectriquement

3. Filtre acoustique selon la revendication 1 ou 2, **caractérisé en ce que** les deux corps (1, 2) sont constitués par le même matériau piézoélectrique et sont de mêmes orientations cristallines, de manière à former un seul corps solide à l'intérieur duquel une structure métallique plane (9, 9', 10) formant le filtre, sert de guide piézoélectrique aux ondes acoustiques d'interface transversales (SH) ou quasi-transversales (Q-SH).

4. Filtre acoustique selon la revendication 3, **caractérisé en ce que** les axes cristallographiques du matériau constituant les deux corps solides sont choisis de manière à ce que la composante transversale du vecteur déplacement (7) des ondes acoustiques dans le plan de l'interface (3) soit la seule composante du vecteur déplacement, le matériau étant piézoélectrique de la classe hexagonale 6 mm dont l'axe cristallographique C est dans le plan de l'interface, perpendiculairement à la direction (Ox) de propagation des ondes acoustiques.

5. Filtre acoustique selon la revendication 3, **caractérisé en ce que** les axes cristallographiques du matériau constituant les deux corps (1, 2) sont choisis de manière à ce que la composante transversale du vecteur déplacement (7) des ondes acoustiques dans le plan de l'interface (3) soit dominante, les deux corps étant obtenus en effectuant une coupe suivant l'axe cristallographique Y, cet axe Y étant tourné d'un certain angle, dans du Niobate de Lithium (YX-LiNbO$_3$) ou du Tantalate de Lithium (YX-LiTaO$_3$), les ondes acoustiques se propageant suivant l'axe cristallographique X du matériau.

6. Filtre acoustique selon la revendication 3, **caractérisé en ce que** les axes cristallographiques du matériau constituant les deux corps (1, 2) sont choisis de telle sorte que la composante transversale du vecteur déplacement (7) des ondes acoustiques dans le plan de l'interface (3) soit dominante, les deux corps étant obtenus en effectuant des coupes suivant l'axe cristallographique ST du quartz (ST-X quartz), les ondes acoustiques se propageant suivant l'axe cristallographique X du matériau.

7. Filtre acoustique selon l'une des revendications 3 à 6, **caractérisé en ce qu'**il est obtenu à partir d'un cristal piézoélectrique unique qui a été coupé selon un plan contenant l'axe de propagation (Ox) des ondes acoustiques et l'axe du vecteur déplacement (7) transverse unique (SH) ou dominant (Q-SH) des ondes acoustiques d'interface transversales ou quasi-transversales choisies, la surface obtenue par la coupe de l'une des parties du cristal ainsi coupé comprenant des sillons gravés d'épaisseur contrôlée, dans lesquels est formée une structure métallique plane (9, 9', 10) de filtre, les deux parties coupées (1, 2) ayant été replacées l'une par rapport à l'autre suivant les mêmes orientations cristallines, et fixées l'une à l'autre au moyen d'une adhérence élastique.

8. Filtre acoustique selon la revendication 1 ou 2,
   **caractérisé en ce que** l'un (1) des corps (1, 2) est piézoélectrique et l'autre (2) est non piézoélectrique, les matériaux constituant les corps (1, 2) étant choisis de manière à ce que la vitesse de propagation des ondes acoustiques transversales ou quasi transversales dans un plan parallèle au plan d'interface (3) dans le matériau non piézoélectrique soit égale ou supérieure à celle dans le matériau piézoélectrique.

9. Filtre acoustique selon la revendication 8,
   **caractérisé en ce que** la constante diélectrique et la densité du matériau non piézoélectrique sont inférieures à la constante diélectrique et à la densité du matériau piézoélectrique.

10. Filtre acoustique selon la revendication 8 ou 9,
    **caractérisé en ce que** pour satisfaire les conditions d'existence des ondes acoustiques d'interface (Q-SH) dont la composante transversale du vecteur déplacement (7) dans le plan de l'interface soit dominante, le cristal d'un des deux corps (1, 2) est tourné légèrement par rapport à l'autre autour d'un axe perpendiculaire au plan de leur interface (3) depuis les orientations cristallines nécessaires pour que les ondes piézoélectriques soient purement transversales (SH) à l'interface (3) entre les deux corps (1, 2).

11. Filtre acoustique selon l'une des revendications 8 à 10,
    **caractérisé en ce que** les deux corps (1, 2) sont obtenus à partir de la coupe de deux matériaux cristallins (A, B) selon des axes cristallographiques adéquats, la surface de l'un des matériaux formant ladite interface (3) comprenant une structure métallique plane (9, 9', 10) de filtre, les deux corps étant fixés l'un à l'autre selon des axes adéquats au moyen d'un procédé d'adhérence élastique.

12. Filtre acoustique selon l'une des revendications 8 à 11,
    **caractérisé en ce que** le corps non piézoélectrique (2) est un cristal de YAG, tandis que le corps piézoélectrique (1) est un cristal de Niobate de Lithium (YX-LiNbO$_3$) ou un cristal de Tantalate de Lithium (YX-LiTaO$_3$), de coupe suivant l'axe cristallographique Y, la propagation se faisant suivant l'axe cristallographique X, les deux corps étant fixés l'un à l'autre selon les axes adéquats au moyen de tout procédé d'adhérence élastique.

13. Filtre acoustique selon l'une des revendications 8 à 11,
    **caractérisé en ce qu'**il est formé par un matériau cristallin dont une surface comprend une structure métallique plane de filtre, l'autre corps étant formé sur cette surface par dépôt ou épitaxie selon les axes adéquats.

14. Filtre acoustique selon la revendication 13,
    **caractérisé en ce qu'**il est réalisé par dépôt de Silicium amorphe sur une surface de Niobate de Lithium (YX-LiNbO$_3$) de coupe suivant l'axe cristallographique Y, où Y est tourné d'un certain angle, la propagation des ondes acoustiques s'effectuant suivant l'axe cristallographique X.

15. Filtre acoustique selon la revendication 13,
    **caractérisé en ce qu'**il est réalisé par épitaxie d'une couche de Nitrure d'Aluminium (AlN) sur une surface de Saphir (Al$_2$O$_3$).

**Patentansprüche**

1. Akustisches Filter von ebener Struktur, bei dem Schallwellen sich im wesentlichen in einer Ebene ausbreiten,
   **dadurch gekennzeichnet, dass** es zwei Festkörper (1, 2) aufweist, von denen mindestens einer piezoelektrisch ist, wobei diese Körper miteinander so verbunden sind, dass sie zwischen sich eine ebene Schnittstelle (3) aufweisen, wobei die Schallwellen vom piezoelektrischen Körper. mittels eines elektrischen Felds erzeugt und von der Schnittstelle zwischen den beiden Festkörpern geleitet werden, wobei die Festkörper so ausgewählt werden, dass diese Wellen eine Schallenergie aufweisen, die in den beiden Körpern ausgehend von der Schnittstelle in einer Richtung (Oy) senkrecht zur Schnittstelle exponentiell abnimmt, wobei der mit diesen Wellen verbundene Verschiebungsvektor der Materieatome sich in einer Ebene senkrecht zur ebenen Schnittstelle (3) befindet, die die beiden Festkörper (1, 2) trennt.

2. Akustisches Filter nach Anspruch 1,
   **dadurch gekennzeichnet, dass** die kristallographischen Achsen der die beiden Körper (1, 2) bildenden Materialien so gewählt werden, dass an der Schnittstelle (3) Transversalschallwellen (SH) oder quasi-Transversalschallwellen (Q-SH) erhalten werden, deren Verschiebungsvektor (7) eine einzige Komponente, die in der Ebene der Schnittstelle (3) transversal ist, oder eine dominante transversale Komponente aufweist, und dass die Welle piezoelektrisch gekoppelt ist.

**3.** Akustisches Filter nach Anspruch 1 oder 2,
**dadurch gekennzeichnet, dass** die beiden Körper (1, 2) aus dem gleichen piezoelektrischen Material bestehen und die gleichen kristallinen Ausrichtungen aufweisen, um einen einzigen Festkörper zu bilden, in dessen Innerem eine ebene metallische Struktur (9, 9', 10), die das Filter bildet, als piezoelektrischer Leiter für die Transversalschallwellen (SH) oder quasi-Transversalschallwellen (Q-SH) der Schnittstelle dient.

**4.** Akustisches Filter nach Anspruch 3,
**dadurch gekennzeichnet, dass** die kristallographischen Achsen des die beiden Festkörper bildenden Materials so gewählt werden, dass die Transversalkomponente des Verschiebungsvektors (7) der Schallwellen in der Ebene der Schnittstelle (3) die einzige Komponente des Verschiebungsvektors ist, wobei das Material ein piezoelektrisches Material der hexagonalen Klasse 6 mm ist, dessen kristallographische Achse C in der Ebene der Schnittstelle senkrecht zur Ausbreitungsrichtung (Ox) der Schallwellen liegt.

**5.** Akustisches Filter nach Anspruch 3,.
**dadurch gekennzeichnet, dass** die kristallographischen Achsen des die beiden Körper (1, 2) bildenden Materials so gewählt werden, dass die Transversalkomponente des Verschiebungsvektors (7) der Schallwellen in der Ebene der Schnittstelle (3) dominant ist, wobei die beiden Körper dadurch erhalten werden, dass ein Schnitt entlang der kristallographischen Achse Y, wobei diese Achse Y um einen bestimmten Winkel gedreht ist, in Lithiumniobat (YX-LiNbO$_3$) oder in Lithiumtantalat (YX-LiTaO$_3$) durchgeführt wird, wobei die Schallwellen sich gemäß der kristallographischen Achse X des Materials ausbreiten.

**6.** Akustisches Filter nach Anspruch 3,
**dadurch gekennzeichnet, dass** die kristallographischen Achsen des die beiden Körper (1, 2) bildenden Materials so gewählt werden, dass die Transversalkomponente des Verschiebungsvektors (7) der Schallwellen in der Ebene der Schnittstelle (3) dominant ist, wobei die beiden Körper dadurch erhalten werden, dass Schnitte entlang der kristallographischen Achse ST des Quarzes (ST-X Quarz) durchgeführt werden, wobei die Schallwellen sich gemäß der kristallographischen Achse X des Materials ausbreiten.

**7.** Akustisches Filter nach einem der Ansprüche 3 bis 6,
**dadurch gekennzeichnet, dass** es ausgehend von einem einzigen piezoelektrischen Kristall erhalten wird, der in einer Ebene geschnitten wurde, die die Ausbreitungsachse (Ox) der Schallwellen und die Achse des einzigen (SH) oder dominanten (Q-SH) Transversal-Verschiebungsvektors (7) der gewählten Transversalschallwellen oder quasi-Transversalschallwellen der Schnittstelle enthält, wobei die durch den Schnitt erhaltene. Oberfläche eines der Teile des so geschnittenen Kristalls eingravierte Rillen von kontrollierter Stärke aufweist, in denen eine ebene metallische Filterstruktur (9, 9', 10) ausgebildet ist, wobei die beiden geschnittenen Teile (1, 2) zueinander gemäß den gleichen kristallinen Ausrichtungen neu angeordnet und mittels eines elastischen Haftens aneinander befestigt worden sind.

**8.** Akustisches Filter nach Anspruch 1 oder 2,
**dadurch gekennzeichnet, dass** einer (1) der Körper (1, 2) piezoelektrisch und der andere (2) nicht piezoelektrisch ist, wobei die die Körper (1, 2) bildenden Materialien so gewählt werden, dass die Ausbreitungsgeschwindigkeit der Transversalschallwellen oder quasi-Transversalschallwellen in einer Ebene parallel zur Schnittstellenebene (3) im nicht piezoelektrischen Material gleich der oder größer als die im piezoelektrischen Material ist.

**9.** Akustisches Filter nach Anspruch 8,
**dadurch gekennzeichnet, dass** die Dielektrizitätskonstante und die Dichte des nicht piezoelektrischen Materials niedriger sind als die Dielektrizitätskonstante und die Dichte des piezoelektrischen Materials.

**10.** Akustisches Filter nach Anspruch 8 oder 9,
**dadurch gekennzeichnet, dass** zur Erfüllung der Bedingungen des Vorhandenseins der Schnittstellen-Schallwellen (Q-SH), deren transversale Komponente des Verschiebungsvektors (7) in der Ebene der Schnittstelle dominant ist, der Kristall eines der Körper (1, 2) ausgehend von den kristallinen Ausrichtungen, die notwendig sind, damit die piezoelektrischen Wellen rein transversal (SH) zur Schnittstelle (3) zwischen den beiden Körpern (1, 2) liegen, in Bezug auf den anderen leicht um eine Achse senkrecht zur Ebene ihrer Schnittstelle (3) gedreht ist.

**EP 1 222 735 B1**

**11.** Akustisches Filter nach einem der Ansprüche 8 bis 10,
**dadurch gekennzeichnet, dass** die beiden Körper (1, 2) ausgehend vom Schnitt zweier kristalliner Materialien (A, B) entlang von geeigneten kristallographischen Achsen erhalten werden, wobei die Oberfläche eines der die Schnittstelle (3) bildenden Materialien eine eben metallische Filterstruktur (9, 9', 10) aufweist, wobei die beiden Körper aneinander gemäß geeigneter Achsen mittels eines Verfahrens des elastischen Haftens befestigt sind.

**12.** Akustisches Filter nach einem der Ansprüche 8 bis 11,
**dadurch gekennzeichnet, dass** der nicht piezoelektrische Körper (2) ein YAG-Kristall ist, während der piezoelektrische Körper (1) ein Kristall aus Lithiumniobat (YX-LiNbO$_3$) oder ein Kristall aus Lithiumtantalat (YX-LiTaO$_3$) mit einem Schnitt gemäß der kristallographischen Achse Y ist, wobei die Ausbreitung gemäß der kristallographischen Achse. X erfolgt, wobei die beiden Körper gemäß den geeigneten Achsen mittels eines beliebigen elastischen Haftungsverfahren aneinander befestigt sind.

**13.** Akustisches Filter nach einem der Ansprüche 8 bis 11,
**dadurch gekennzeichnet, dass** es von einem kristallinen Material gebildet wird, von dem eine Oberfläche eine ebene metallische Filterstruktur aufweist, während der andere Körper auf dieser Oberfläche durch Beschichtung oder Epitaxie gemäß. den geeigneten Achsen gebildet wird.

**14.** Akustisches Filter nach Anspruch 13,
**dadurch gekennzeichnet, dass** es durch Aufbringen von amorphem Silicium auf eine Lithiumrüobatoberfläche (YX-LiNbO$_3$) mit einem Schnitt gemäß der kristallographischen Achse Y hergestellt wird, wobei Y um einen bestimmten Winkel gedreht ist, wobei die Ausbreitung der Schallwellen gemäß der kristallographischen Achse X erfolgt.

**15.** Akustisches Filter nach Anspruch 13,
**dadurch gekennzeichnet, dass** es durch Epitaxie einer Schicht aus Aluminiumnitrid (AlN) auf eine Saphiroberfläche (Al$_2$O$_3$)hergestellt wird.

**Claims**

**1.** Plane structure acoustic filter in which acoustic waves spread substantially inside a plane,
**characterised in that** it includes two solid bodies (1, 2), at least one of these being piezoelectric, these bodies being linked to each other so as to have a plane interface (3) between them, the acoustic waves being generated by the piezoelectric body with the aid of an electric field and guided by the interface between the two solid bodies, the latter being selected so that these waves have an acoustic energy these decreases exponentially in the two bodies from the interface in a direction (Oy) perpendicular to the interface, the displacement vector of the atoms of the materials linked to these waves situated in the perpendicular plane to said plane interface (3) separating said two solid bodies (1, 2).

**2.** Acoustic filter according to claim 1,
**characterised in that** the crystallographic axes of the materials constituting the two bodies (1, 2) are selected so as to obtain at the interface (3) transversal acoustic waves (SH) or quasi-transversal waves (Q-SH) whose displacement vector (7) has a single component which is transversal inside the plane of the interface (3) or a dominant transversal component, and when the wave is coupled piezoelectrically.

**3.** Acoustic filter according to claim 1 or 2,
**characterised in that** the two bodies (1, 2) are made of the same piezoelectric material and have the same crystalline orientations so as to form a single solid body inside which a plane metal structure (9, 9', 10) forming the filter serves as a piezoelectric guide for the transversal (SH) or quasi-transversal (Q-SH) interface acoustic waves.

**4.** Acoustic filter according to claim 3,
**characterised in that** the crystallographic axes of the material constituting the two solid bodies are selected so that the transversal component of the displacement vector (7) of the acoustic waves inside the plane of the interface (3) is the sole component of the displacement vector, the material being piezoelectric from the 6 mm hexagonal category whose crystallographic axis C is inside the plane of the interface perpendicular to the direction (Ox) of propagation of the acoustic waves.

5. Acoustic filter according to claim 3,
**characterised in that** the crystallographic axes of the material constituting the two bodies (1, 2) are selected so that the transversal component of the displacement vector (7) of the acoustic waves inside the plane of the interface (3) is dominant, the two bodies being obtained by making a cut along the crystallographic axis Y, this axis Y being orientated by a certain angle in lithium niobate (YX-LiNbO$_3$) or lithium tantalate (YX-LiTaO$_3$), the acoustic waves spreading along the crystallographic axis X of the material.

6. Acoustic filter according to claim 3,
**characterised in that** the crystallographic axes of the material constituting the two bodies (1, 2) are selected so that the transversal component of the displacement vector (7) of the acoustic waves inside the plane of the interface (3) is dominant, the two bodies being obtained by making cuts along the crystallographic axis ST of the quartz (ST-X quartz), the acoustic waves spreading along the crystallographic axis X of the material.

7. Acoustic filter according to one of claims 3 to 6,
**characterised in that** it is obtained from a sole piezoelectric crystal which has been cut along a plane containing the propagation axis (Ox) of the acoustic waves and the axis of the sole transverse (SH) or dominant (Q-SH) displacement vector (7) of the selected transversal or quasi-transversal interface acoustic waves, the surface obtained by the cut of one of the portions of the cut crystal including etched grooves with a controlled thickness in which a plane metal filter structure (9, 9', 10) is formed, the two cut portions (1, 2) having been replaced by each other along the same crystalline orientations and fixed to each other by an elastic adherence element.

8. Acoustic filter according to claim 1 or 2,
**characterised in that** one (1) of the bodies (1, 2) is piezoelectric and the other (2) is non-piezoelectric, the materials constituting the bodies (1, 2) being selected so that the speed of propagation of the transversal or quasi-transversal acoustic waves inside a plane parallel to the interface plane (3) in the non-piezoelectric material is equal to or greater than that in the piezoelectric material.

9. Acoustic filter according to claim 8,
**characterised in that** the dielectric constant and density of the non-piezoelectric material are less than the dielectric constant and density of the piezoelectric material.

10. Acoustic filter according to claim 8 or 9,
**characterised in that** so as to satisfy the conditions of existence of the interface acoustic waves (Q-SH) for which the transversal component of the displacement vector (7) inside the plane of the interface is dominant, the crystal of one of the two bodies (1, 2) is orientated slightly with respect to the other around an axis perpendicular the plane of their interface (3) from the crystalline orientations required so that the piezoelectric waves are purely transversal (SH) at the interface (3) between the two bodies (1, 2).

11. Acoustic filter according to one of claims 8 to 10,
**characterised in that** the two bodies (1, 2) are obtained from the cut of two crystalline materials (A, B) along suitable crystallographic axes, the surface of one of the materials forming said interface (3) including a plane metal filter structure (9, 9', 10), the two bodies being fixed to each other along suitable axes by means of an elastic adherence method.

12. Acoustic filter according to one of claims 8 to 11,
**characterised in that** the non-piezoelectric body (2) is a YAG crystal, whereas the piezoelectric body (1) is a lithium niobate crystal (YX-LiNbO$_3$) or a lithium tantalate crystal (YX-LiTaO$_3$), with a cut along the crystallographic axis Y, propagation being effected along the crystallographic axis X, the two bodies being fixed to each other along the suitable axes by means of any elastic adherence method.

13. Acoustic filter according to one of claims 8 to 11,
**characterised in that** it is formed by a crystalline material having a surface including a plane metallic filter structure, the other body being formed on this surface by a deposit or epitaxial growth along the suitable axes.

14. Acoustic filter according to claim 13,
**characterised in that** it is embodied by a deposit of amorphous silicon on a surface of lithium niobate (YX-LiNbO$_3$) with a cut along the crystallographic axis Y where Y is orientated by a certain angle, propagation of the acoustic waves being effected along the crystallographic axis X.

**15.** Acoustic filter according to claim 13,
**characterised in that** it is embodied by an epitaxial growth of a film of aluminium nitride (AlN) on a sapphire surface ($Al_2O_3$).

matériau B

y

6

2

O

x

z

7

3

6

5

matériau A

FIG. 1

1

matériau B

2

9'

3

9

10

matériau A

1

FIG. 2

FIG. 3